(19) Europäisches Patentamt
European Patent Office
Office européen des brevets

(11) **EP 2 062 360 B1**

(12) **EUROPÄISCHE PATENTSCHRIFT**

(45) Veröffentlichungstag und Bekanntmachung des Hinweises auf die Patenterteilung:
**01.12.2010 Patentblatt 2010/48**

(21) Anmeldenummer: **07786408.0**

(22) Anmeldetag: **28.07.2007**

(51) Int Cl.:
***H03K 17/955*** *(2006.01)*   ***E05F 15/00*** *(2006.01)*
***H03K 17/96*** *(2006.01)*

(86) Internationale Anmeldenummer:
**PCT/EP2007/006698**

(87) Internationale Veröffentlichungsnummer:
**WO 2008/025423 (06.03.2008 Gazette 2008/10)**

(54) **EINKLEMMSCHUTZ**

ANTI-TRAPPING DEVICE

PROTECTION ANTI-COINCEMENT

(84) Benannte Vertragsstaaten:
**DE FR**

(30) Priorität: **30.08.2006   DE 202006013337 U**

(43) Veröffentlichungstag der Anmeldung:
**27.05.2009   Patentblatt 2009/22**

(73) Patentinhaber: **Brose Fahrzeugteile GmbH & Co. Kommanditgesellschaft Coburg**
**96450 Coburg (DE)**

(72) Erfinder:
• **WÜRSTLEIN, Holger**
  **97475 Zeil am Main (DE)**
• **WEINGÄRTNER, Thomas**
  **96117 Memmelsdorf (DE)**
• **MÜLLER, Wolf-Christian**
  **96450 Coburg (DE)**

(74) Vertreter: **Tergau & Pohl Patentanwälte**
**Mögeldorfer Hauptstrasse 51**
**90482 Nürnberg (DE)**

(56) Entgegenhaltungen:
WO-A-97/01835        US-A1- 2003 085 679
US-A1- 2006 117 862

EP 2 062 360 B1

**Beschreibung**

Die Erfindung betrifft einen Einklemmschutz, umfassend einen Motor zum Antrieb eines schwenkbaren Stellelements eines Kraftzeugs, einen Sensor zum berührungslosen Erkennen eines Hindernisses im Weg des Stellelements sowie eine Steuereinheit.

Bekannte Einklemmschutzsysteme nutzen zum Erkennen eines Hindernisses insbesondere Sensoren, die auf dem kapazitiven Messprinzip aufgebaut sind. Dabei wird zwischen einer Messelektrode und einer geeigneten Gegenelektrode ein elektrisches Feld aufgebaut. Tritt in dieses elektrische Feld ein Dielektrikum, d.h. ein Fremdkörper, ein, so verändert sich die Kapazität des von der Messelektrode und der Gegenelektrode gebildeten Kondensators. Auf diese Weise kann theoretisch jedes Hindernis im Weg des Stellelements eines Kraftfahrzeugs detektiert werden, dessen relative Dielektrizitätszahl $\varepsilon_r$ sich von der relativen Dielektrizitätszahl von Luft unterscheidet. Das Hindernis im Weg eines Stellelements wird ohne einen physischen Kontakt mit dem Einklemmsensor erkannt. Wird eine Kapazitätsänderung detektiert, so können rechtzeitig Gegenmaßnahmen, wie beispielsweise ein Stoppen oder ein Reversieren des Antriebs des Stellelements eingeleitet werden, bevor es zu einem tatsächlichen Einklemmen des Hindernisses kommt.

Berührungslos arbeitende, auf dem kapazitiven Messprinzip beruhende Einklemmsensoren sind beispielsweise aus der EP 1 455 044 A2 und der EP 1 154 110 A2 bekannt. Beide Sensoren erzeugen mittels einer Messelektrode und einer geeigneten Gegenelektrode ein äußeres elektrisches Feld, so dass ein in dieses äußere elektrische Feld eindringendes Dielektrikum als eine Kapazitätsänderung zwischen Messelektrode und Gegenelektrode detektiert werden kann. Um eine hohe Sicherheit bei der Detektion eines Einklemmfalles gewährleisten zu können, ist zusätzlich bei beiden vorbekannten Einklemmsensoren der Abstand zwischen Messelektrode und Gegenelektrode veränderbar gestaltet, wodurch auch ein physischer Kontakt eines Hindernisses mit dem Einklemmsensor als eine Kapazitätsänderung detektierbar wird.

Auch aus der US 2006/0117862 A1 ist ein Einklemmschutz der eingangs genannten Art bekannt. Zu einer insbesondere berührungslosen Detektion eines Hindernisses im Wege eines schwenkbaren Stellelements eines Kraftfahrzeugs wird ein in Segmente unterteilter Sensor offenbart. Dieser Sensor ist der feststehenden Karosserie des Kraftfahrzeugs zugeordnet. Werden alle Segmente zugleich angesprochen, wird hieraus auf einen Schließzustand des Stellelements geschlossen.

Nachteiligerweise genügt insbesondere bei einem schwenkbaren Stellelement eines Kraftfahrzeugs, wie beispielsweise einer elektrisch betätigbaren Heckklappe, einer elektrisch betätigbaren Motorhaube oder einer elektrisch betätigbaren Kraftzeugtür, die üblicherweise veranschlagte Reaktionszeit zwischen dem Auftreten eines Störsignals und einem Bewegungsstopp des Stellelements aufgrund der auftretenden hohen Bahngeschwindigkeiten nicht, um einen Einklemmfall stets sicher zu vermeiden.

Aufgabe der Erfindung ist es, einen Einklemmschutz oder ein Einklemmschutzsystem mit einer möglichst hohen Sicherheit für die Vermeidung eines Einklemmfalles insbesondere im Falle eines schwenkbaren Stellelementes anzugeben.

Diese Aufgabe wird erfindungsgemäß durch die Merkmalskombination des Anspruchs 1 gelöst.

Die Erfindung geht dabei in einem ersten Schritt von der Überlegung aus, dass beim Schließen eines schwenkbaren Stellelements die Bahngeschwindigkeit mit zunehmendem radialen Abstand zur Drehachse wächst. Folglich verbleibt bei einem Schließvorgang mit einer in der Regel konstanten Winkelgeschwindigkeit für ein Hindernis, welches sich drehachsennah im Stellweg des Stellelements befindet, eine größere Zeitspanne zwischen dem Erkennen des Hindernisses und dem Einklemmen des Hindernisses als bei einem Hindernis, welches sich drehachsenfern im Stellweg befindet. Da das Hindernis von dem berührungslosen kapazitiven Sensor bei Eintritt in einen Detektionsraum mit fester räumlicher Ausdehnung detektiert wird, verbleibt somit dem Einklemmschutz im Falle des drehachsenfernen Hindernisses keine ausreichende Reaktionszeit zur Vermeidung des Einklemmfalles.

In einem zweiten Schritt erkennt die Erfindung, dass sich die Sicherheit zur Vermeidung eines Einklemmfalles erhöhen lässt, wenn eine Positionserkennung eines in den Weg eines schwenkbaren Stellelements eindringenden Fremdkörpers ermöglicht wird. In diesem Fall kann nämlich die Reaktionszeit des Einklemmschutzsystems an den radialen Abstand des Hindernisses zur Drehachse bzw. an die unterschiedlichen Bahngeschwindigkeiten angepasst werden. Gerade im Falle eines drehachsenfernen Hindernisses kann somit der Motor entsprechend angesteuert werden, so dass das Stellelement rechtzeitig vor einem Einklemmfall abgebremst ist oder in die Öffnungsrichtung betrieben wird.

Zur Positionserkennung ist die Elektrode des Sensors in mehrere Segmente unterteilt, die als separate Elektroden jeweils zur Generation eines Störsignals für eine kapazitive berührungslose Detektion eines Hindernisses auswertbar sind. Die Kapazität jedes Elektrodensegments gegenüber der Gegenelektrode ist somit einzeln messbar. Somit ist die Steuereinheit in der Lage, ein als Kapazitätsänderung detektiertes Störsignal einem Segment zuzuordnen, wodurch die Position des Hindernisses über die Position des Segments je nach Anzahl der Segmente hinreichend aufgelöst lokalisierbar ist.

Die Elektrode erstreckt sich in eine Radialrichtung bezüglich des schwenkbaren Stellelements. Dadurch ist mittels der Segmentierung eine Erfassung des radialen Abstandes des Hindernisses von der Drehachse möglich, so dass die dem festgestellten Radialabstand entsprechende Ansteuerung des Motors für ein rechtzeitiges Abbremsens des Stellelements von der Steuereinheit gewählt oder vorgegeben werden kann.

Ein derart ausgestalteter berührungsloser Sensor erlaubt grundsätzlich die Detektion einer Kapazitätsänderung mittels eines Multiplex-Verfahrens. Dabei können die einzelnen Segmente mittels separaten Zuleitungen entweder zeitlich versetzt (seriell) oder gleichzeitig (parallel) angesteuert werden. Die erste, serielle Besteuerung bietet den Vorteil, dass hierbei nur eine einzige Auswerteschaltung zur Kapazitätsänderung notwendig wird. Allerdings ist hierbei die Zeitkonstante zu beachten, bis alle Segmente nacheinander durchgeschaltet worden sind. Die zweite parallele Ansteuerung weist zwar die nachteilige Zeitverzögerung nicht auf, erfordert jedoch zur Auswertung mehrere Auswerteelektroniken, wodurch die Kosten erhöht werden.

In der Regel ist die durch einen in den Weg eines Stellelements eindringenden Fremdkörper verursachte Kapazitätsänderung klein. Eine solche Änderung der Kapazität kann jedoch um so besser detektiert werden, je kleiner die sich insgesamt zwischen Elektrode und Gegenelektrode ausbildende Kapazität ist. Ein besonderer Vorteil des segmentierten Sensors ist somit, dass die zwischen der Elektrode und der Gegenelektrode ausgebildete Kapazität sich dadurch verringern lässt, dass eine Sensorelektrode eingesetzt wird, die in die mehreren Segmente unterteilt ist, d.h. es liegt eine hohe Detektionsempfindlichkeit vor.

Zur Einstellung der Reaktionszeit des Einklemmschutzsystems in Abhängigkeit vom Radialabstand des Hindernisses ist die Steuereinheit zu einer Ansteuerung des Motors zum Antrieb des schwenkbaren Stellelements in Abhängigkeit von einem Störsignal eines der Segmente eingerichtet. Hierbei können unterschiedliche Vorgehensweisen zum Stoppen, Anhalten oder zum Reversieren des Motors vorgesehen werden, die je nach Position des Hindernisses einen möglichst mechanikschonenden Betrieb des Motors bei einer hohen Sicherheit gegen ein Einklemmen bieten.

Gemäß einer bevorzugten Ausgestaltung ist die Steuereinheit dafür eingerichtet, bei einem von einem ersten radial innenliegenden Segment generierten Störsignal den Motor langsamer anzuhalten als bei einem Störsignal von einem zweiten radial außenliegenden Segment. Das Anhalten kann dabei durch ein Abbremsen oder durch ein Stoppen des Motors eingeleitet werden. Während einer Schwenkbewegung ist die Winkelgeschwindigkeit für das Stellelement unabhängig vom radialen Abstand gleich. Der radial innere Bereich weist jedoch eine kleinere Bahngeschwindigkeit auf als der radial äußere Bereich. Ausgehend von dieser Erkenntnis wird bei einem Störsignal des ersten Segments, das zur Detektion von Hindernissen im Weg eines radial innenliegenden Bereiches des Stellelements eingesetzt ist, die Zeit bis zum Stillstand des Motors und somit des Stellelements länger eingestellt, als bei einem Störsignal des zweiten Segments.

Vorzugsweise ist die Steuereinheit dafür eingerichtet, den Motor zum Anhalten reversibel anzusteuern. Hierdurch wird ein rasches Abbremsen erreicht. Auch ändert das Stellelement gleich nach seinem Stillstand seine Richtung, so dass es gegebenenfalls das Hindernis oder den Fremdkörper freigibt, falls er in Kontakt mit dem Stellelement gekommen ist. Eine solche Ansteuerung des Motors bietet eine hohe Betriebssicherheit. Allerdings führt eine reversierende Ansteuerung entgegen der Bewegungsrichtung zu einer erhöhten Belastung sowohl des Motors wie auch des Getriebes und des Antriebsstranges.

In einer vorteilhaften Ausführungsvariante weist die Elektrode eine erste radial innenliegende, eine zweite radial mittige und eine dritte radial außenliegende Segmentgruppe auf. Dabei wird das Stellelement in Abhängigkeit von der das Störsignal generierenden Segmentgruppe entsprechend angesteuert. Eine Segmentgruppe umfasst hierbei ein oder mehrere anliegende Segmente, wobei bei einem Störsignal aus dem Segment einer Gruppe die Steuereinheit auf etwa die gleiche Weise den Motor bzw. das Stellelement ansteuert.

Bevorzugt ist die Steuereinheit dafür eingerichtet, bei einem Störsignal aus der ersten Segmentgruppe den Motor zunächst sanft anzuhalten. Insbesondere wird der Motor erst nach dem Stillstand zum Anlaufen in Reversierrichtung angesteuert. Aufgrund der radial inneren Lage der ersten Segmentgruppe ist die Bahngeschwindigkeit des Stellelements in dem Detektionsbereich dieser Segmentgruppe niedriger als im Bereich der beiden weiteren Segmentgruppen. Somit ist eine Verzögerung des Anhaltevorganges bzw. ein schrittweises Anhalten oder sanftes Abbremsen vor der Richtungsänderung des Stellelements möglich, was den Motor wenig beansprucht, ohne dass dadurch die Einklemmsicherheit beeinträchtigt wird.

Zweckdienlicherweise ist die Steuereinheit dafür eingerichtet, über eine PWM-Regelung, also über ein Puls-Weiten-Moduliertes Spannungs- oder Stromsignal den Motor anzusteuern. Die PWM-Regelung ermöglicht insbesondere eine Variierung der Drehgeschwindigkeit des Motors bzw. der Winkelgeschwindigkeit des Stellelements durch eine Änderung des Tastverhältnisses, so dass das sanfte, graduelle Abbremsen des Motors bei einem von der ersten Segmentgruppe detektierten Fremdkörper im Weg des Stellelements ohne zusätzlichen Aufwand durchgeführt werden kann.

Weiter bevorzugt ist die Steuereinheit dafür eingerichtet, bei einem Störsignal aus der zweiten Segmentgruppe den Motor sofort abzuschalten. Da im mittleren Bereich des Stellelements die Bahngeschwindigkeit des Stellelements höher ist als im radial inneren Bereich, ist eine schnellere Reaktion auf ein Hindernis erforderlich, was durch ein unverzügliches Abschalten des Motors erreicht wird. Nach dem Abschalten des Motors wird das System aufgrund der eigenen Trägheit und aufgrund der systeminhärenten Federraten nachlaufen, bis die gespeicherte Energie aufgebraucht ist. Der Motor kann gegebenenfalls nach dem Stillstand in Reversierrichtung angesteuert werden. Insgesamt ergibt sich somit wiederum eine mechanikschonende Betriebsweise.

Der radial äußere Bereich des Stellelements weist die höchste Bahngeschwindigkeit auf und, um einen einklemmsicheren Betrieb des Stellelements zu gewährleisten, sind im Falle eines detektierten Hindernisses sofortige Einklemmschutzmaßnahmen erforderlich. Daher ist die Steuereinheit vorzugsweise dafür eingerichtet, bei einem Störsignal aus der dritten Segmentgruppe den Motor unverzüglich in Reversierrichtung anzusteuern.

Gemäß einer bevorzugten Ausgestaltung des Einklemmschutzes ist vorgesehen, dass mindestens eine der Segmentgruppen derart ausgebildet ist, dass ein im Wesentlichen stufenloser Übergang beim Ansteuern des Motors bezüglich der benachbarten Segmente innerhalb der Segmentgruppe erfolgt. Ein stufenloser Übergang beim Ansteuern des Motors liegt insbesondere dann vor, wenn die Segmentgruppe eine Vielzahl von Segmenten umfasst. Am Beispiel der ersten Segmentgruppe bedeutet dies, dass in Abhängigkeiten von dem Segment dieser Segmentgruppe, welches das Störssignal generiert hat, eine unterschiedlich schnelle Abbremsung des Motors veranlasst wird. Der stufenlose Übergang kann sich außerdem über die Segmentgruppen erstrecken.

Vorteilhafterweise ist die Elektrode in einem flexiblen Träger geführt. Ein derartiger Träger erlaubt eine Anpassung des Einklemmsensors an die gegebenen Konturen eines Kraftfahrzeugs. Insbesondere kann der Sensor insgesamt als ein flexibles Flachbandkabel ausgeformt sein. Auch kann ist es vorstellbar, den Sensor als einen Dichtkörper auszugestalten oder den Sensor in einen Dichtkörper zu integrieren. Der Dichtkörper ist dabei vorgesehen, das Stellelement gegenüber der Schließkante in einem geschlossenen Zustand abzudichten.

Ein flexibles Flachbandkabel wird auch als FFC ("Flexible Flat Cable") bezeichnet, und zeichnet sich dadurch aus, dass in einem flexiblen Kabelkörper parallele Leiterstrukturen verlegt sind. Alternativ zu einem FFC kann auch eine flexible Leiterstruktur verwendet werden. Eine flexible Leiterstruktur ist auch unter dem Begriff FPC ("Flexible Printed Circuit") bekannt. Dabei sind in einem flexiblen Isoliermaterial, insbesondere in mehrschichtiger Anordnung, Leiterbahnen spezifisch angeordnet oder verlegt. Eine solche Ausgestaltung erlaubt eine hohe Flexibilität hinsichtlich der Dimensionierung und Anordnung der einzelnen Leiterbahnen.

Weiter von Vorteil ist es, wenn im flexiblen Träger zusätzlich eine Abschirmelektrode zur Richtung des elektrischen Feldes in einen Gefährdungsbereich vorgesehen ist. Die Elektrode und die Abschirmelektrode sind im Wesentlichen gegenüber angeordnet und voneinander isoliert. Dabei befindet sich die Abschirmelektrode auf demselben Potential wie die Elektrode. Wird eine solche Abschirmelektrode zwischen Elektrode und Gegenelektrode eingeführt, so wird das sich zwischen Elektrode und Abschirmelektrode ausbildende elektrische Feld und somit eine direkte Kapazität deutlich verringert. Nach Art eines Streufeldkondensators bildet sich durch diese Ausgestaltung zwischen der Elektrode und der Gegenelektrode ein elektrisches Feld aus, das weit in den Raum hinein gerichtet ist. Hierdurch wird der Detektionsraum bzw. die Reichweite des Sensors deutlich erhöht.

Zweckmäßigerweise ist auch die Abschirmelektrode in elektrisch kontaktierte Abschirmsegmente unterteilt, zwischen denen isoliert separate Zuleitungen angeordnet sind. Hierdurch wird sicher vermieden, dass zwischen den Zuleitungen und der Gegenelektrode eine Kapazität ausgebildet wird. Jede Zuleitung wird auf diese Weise gegenüber der Gegenelektrode abgeschirmt.

Vorteilhafterweise ist weiter ein Schaltmittel zur Potenzialangleichung zwischen der Elektrode und der Abschirmelektrode vorgesehen. Hierdurch wird erreicht, dass sich kein elektrisches Feld zwischen Elektrode und Abschirmelektrode ausbildet.

Zur Potenzialangleichung ist zweckmäßiger Weise ein Verstärker vorgesehen, der eingangsseitig mittels einer Signalleitung mit der Elektrode und ausgangsseitig mit der Abschirmelektrode zur Versorgung mit einem aus der Signalleitung abgeleiteten Signal verbunden ist. Hierdurch wird in einfacher Art und Weise erzielt, dass sich die Abschirmelektrode stets auf demselben Potenzial befindet wie die Elektrode. Eine Änderung der Kapazität aufgrund Potenzialschwankungen zwischen der Elektrode und der Abschirmelektrode wird hierdurch sicher vermieden. Besonders günstig ist es hierbei, die Abschirmelektrode niederohmig anzusteuern.

Nach einer bevorzugten Variante umfasst der Einklemmschutz zusätzlich einen taktilen Sensor. Der taktile Sensor ist als eine Art Back-up-Sensor vorgesehen, der ein Hindernis auch bei einer Störfunktion des berührungslosen Sensors detektieren soll. Der taktile Sensor kann auch auf einem kapazitiven Messprinzip aufbauen. Hierbei zeigt er bei einer Berührung beispielsweise aufgrund einer durch die Berührung hervorgerufenen Kraft- bzw. Druckwirkung eine Kapazitätsänderung, die von der Steuereinheit detektiert und ausgewertet wird. Der taktile Sensor ist insbesondere ebenfalls wie der berührungslose Sensor in unterschiedliche Segmente bzw. Segmentgruppen unterteilt.

Nach einer weiteren bevorzugten Variante, die sich durch einen geringen Platzbedarf auszeichnet, ist der berührungslose Sensor zugleich als taktiler Sensor ausgestaltet. Ein solcher kombinierter berührungsloser und taktiler Sensor kann geschaffen werden, indem zusätzlich zu der Elektrode, der Gegenelektrode und der Abschirmelektrode eine Grundelektrode sowie eine Innenelektrode vorgesehen sind, wobei die Abschirmelektrode und die Innenelektrode durch die Grundelektrode, welche mit dem Grundpotential verbunden ist, voneinander getrennt sind. Wenigstens die Grundelektrode und die Innenelektrode sind in ein elektrisch isolierendes, elastisches Material eingebettet. Die Einheit umfassend die Grundelektrode, die Innenelektrode und das zwischen den Elektroden angeordnete elastische Material bildet einen taktilen kapazitiven Sensor. Hierbei wird zur taktilen Detektion eines Hindernisses die zwischen der Innenelektrode und der Grundelektrode gebildete Kapazität herangezogen. Wenn eine Krafteinwirkung auf den Sensor durch ein externes Hindernis erfolgt, wird das elastische Material komprimiert und seine Dicke verändert sich. Somit verändert sich der Abstand zwischen der Innenelektrode und der Grundelektrode, was zu einer detektierbaren Kapazitätsänderung des taktilen kapazitiven Sensor führt. Somit wird eine Berührung des Sensors durch das Hindernis detektiert.

Fällt die berührungslose Detektion aus, so erfolgt das Erkennen eines Hindernisses immer noch infolge der Detektion der mechanischen Einwirkung auf den Sensor, wodurch sich die zwischen der Innen- und der Abschirmelektrode gebildete Kapazität verändert.

Der Sensor kann in einfacher Art und Weise zum Erkennen eines Hindernisses im Weg eines Stellelements eines Kraftfahrzeugs eingesetzt werden, wenn als Gegenelektrode die geerdete Karosserie des Kraftfahrzeugs dient. Hierzu wird der beschriebene Sensor derart entlang von Konturen des Kraftfahrzeugs geführt, dass die Abschirmelektrode zwischen der Karosserie und der Elektrode zum Liegen kommt. Die Auswerteschaltung detektiert hierbei die sich zwischen der Elektrode und der geerdeten Karosserie gebildete Kapazität. Der Sensor ist bevorzugt an einem beweglichen Teil des Stellelements angeordnet, beispielsweise an einer Heckklappe des Kraftfahrzeugs, er kann aber auch an einem der Heckklappe gegenüberliegenden Bereich der Karosserie angeordnet sein.

Ausführungsbeispiele der Erfindung werden anhand einer Zeichnung näher erläutert. Dabei zeigen:

Fig. 1    schematisch eine Seitenansicht eines Kraftfahrzeugs,

Fig. 2    in einer Aufsicht einen durch eine flexible Leiterstruktur realisierten Sen- sor,

Fig. 3    in einer stark vereinfachten Darstellung eine Seitensicht auf eine Heck- klappe eines Kraftfahrzeugs, und

Fig. 4    in einem Querschnitt einen kombinierten berührungslosen und taktilen kapazitiven Sensor.

Gleiche Bezugsteile haben in den verschiedenen Figuren die gleiche Bedeutung.

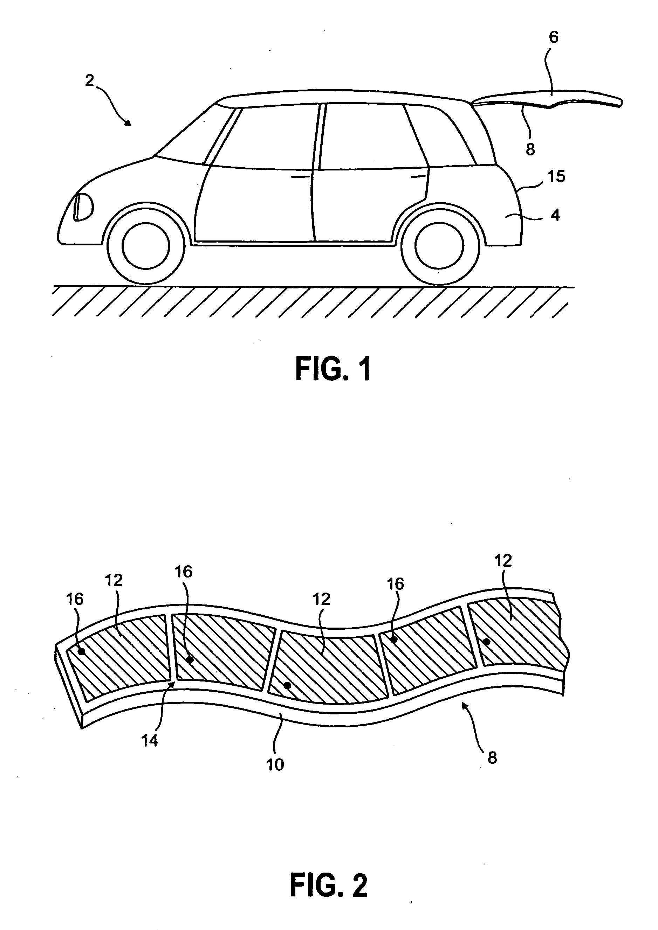

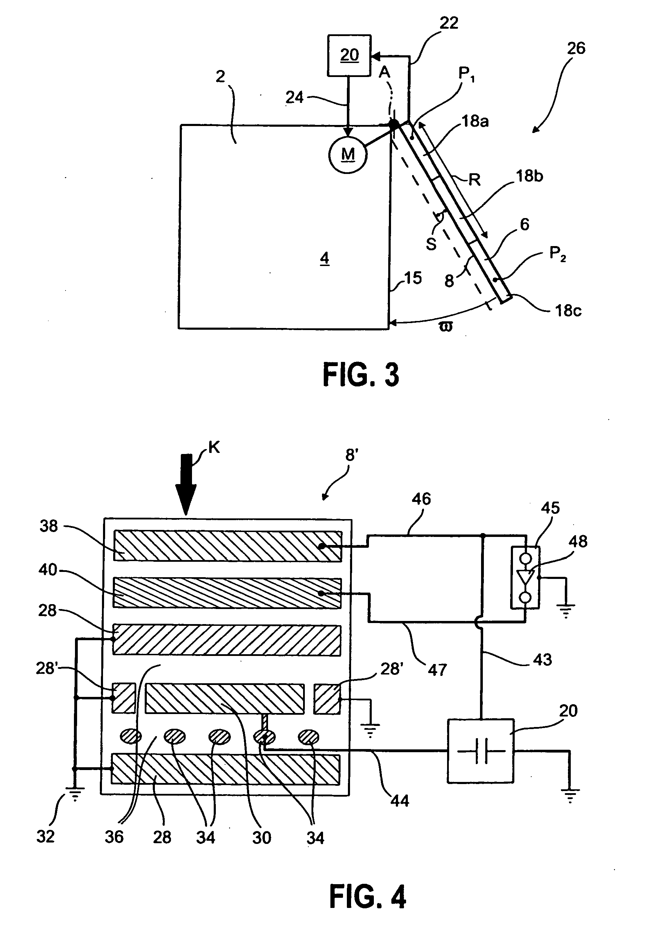

Fig. 1 zeigt schematisch eine Seitenansicht eines Kraftfahrzeugs 2 mit einer Karosserie 4 und einer offenen Heckklappe 6. Die Heckklappe 6 stellt ein schwenkbares Stellelement dar, das durch einen Motor M (siehe Fig. 3) elektrisch angetrieben wird. Beim Schließen der Heckklappe 6 muss sichergestellt werden, dass sich in ihrem Bewegungsbereich, weiterhin auch Gefährdungsbereich genannt, kein Hindernis befindet. Zu diesem Zweck ist entlang der Seitenkanten sowie entlang eines unteren Randes der Heckklappe 6 ein insbesondere als Flachbandkabel ausgebildeter Sensor 8 angebracht. In dem Sensor 8 befinden sich - hier nicht dargestellt - mehrere Segmente einer Elektrode 14 (siehe Fig. 2), die zur Ansteuerung separate Zuleitungen aufweisen. Als Gegenelektrode 15 dient die geerdete Karosserie 4 des Kraftfahrzeugs 2.

In Fig. 2 ist der Sensor 8 in einer Aufsicht dargestellt. Man erkennt hierbei die flexible Leiterstruktur 10, die sich leicht entlang einer Kontur des Kraftfahrzeugs 2 führen lässt. Zur Verdeutlichung des Aufbaus ist auf der Oberseite des Sensors 8 das Isolationsmaterial entfernt bzw. nicht eingezeichnet. Aus diesem Grund sind die in Längsrichtung der flexiblen Leiterstruktur 10 unterbrochenen einzelnen Segmente 12 der Elektrode 14 deutlich sichtbar. Jedes dieser Segmente 12 weist eine Durchkontaktierung 16 auf, die mit einer separaten Zuleitung verbunden ist. Auf diese Weise ist zur Auswertung des Sensors 8 ein Multiplex-Verfahren anwendbar. Die Segmente 12 werden zeitlich versetzt nacheinander einzeln angesteuert und die hierdurch gebildete Kapazität wird erfasst. Aufgrund der verringerten Fläche der Segmente 12 gegenüber einer durchgängig verlaufenden Leiterbahn ist die Kapazität zwischen den Segmenten 12 und der Gegenelektrode 15 weiter verringert. Dies erlaubt eine weitere Erhöhung der Detektionsempfindlichkeit.

Die Bewegung der Heckklappe 6 beim Schließen ist in einer stark vereinfachten Darstellung des Kraftfahrzeugs 2 in Fig. 3 gezeigt. Die Heckklappe 6 ist um eine Drehachse A an der Karosserie 4 schwenkbar angeordnet, welche Drehachse A senkrecht zur Zeichnungsebene verläuft und mit dem Punkt A bezeichnet ist. Vom Punkt A aus erstreckt sich die Heckklappe 6 in eine Radialrichtung R.

Beim Schließen bewegt sich die Heckklappe 6 mit einer mittleren Winkelgeschwindigkeit m auf die Karosserie 4 zu, die für alle radialen Bereiche der Heckklappe 6 gilt. Unter Berücksichtigung der Korrelation zwischen der Bahngeschwindigkeit u und der Winkelgeschwindigkeit $\overline{\omega}$ eines Objekts

$$u = \overline{\omega}^* r$$

ergibt sich, dass die unterschiedlichen Punkte der Heckklappe 6, die unterschiedliche Radialentfernung r von der Drehachse A aufweisen, sich unterschiedlich schnell auf die Karosserie 4 zu bewegen. Wenn z.B. ein Punkt $P_1$, der radial innenliegend positioniert ist, und ein Punkt $P_2$, der radiale außenliegend positioniert ist, gewählt werden, so bewegt sich der Punkt $P_1$ langsamer in Richtung der Karosserie 4 als der Punkt $P_2$. Mit anderen Wort weisen drehachsenferne Punkte eine höhere Bahngeschwindigkeit auf als drehachsennahe Punkte.

Diese Erkenntnis wird bei der Ansteuerung der Heckklappe 6 eingesetzt. Hierzu ist der Sensor 8 in Radialrichtung R in unterschiedliche Segmentgruppen 18a, 18b, 18c unterteilt ist, bzw. sind die einzelnen Segmente 12 in den Segmentgruppen 18a, 18b, 18c gruppiert. Jedes Segment 12 innerhalb der Segmentgruppen 18a, 18b, 18c liefert einer Steuereinheit 20 über eine Signalleitung 22 gegebenenfalls mittels einer entsprechenden Auswerteelektronik ein Messsignal, im vorliegenden Fall ein Kapazitätssignal. Die Steuereinheit 20 wertet dieses Signal im Hinblick auf eine Kapazitätsänderung aus und abhängig davon, welches Segment 12 ein Hindernis im Gefährdungsbereich erfasst hat, steuert sie über eine Steuerleitung 24 entsprechend den Motor M, der die Heckklappe 6 antreibt. Die Steuereinheit 20 ist in Fig. 3 schematisch außerhalb der Karosserie 4 dargestellt. Sie kann allerdings auch in eine Türelektronik oder in die Steuerelektronik des Kraftfahrzeugs 2 integriert sein. Der Sensor 8, die Steuereinheit 20 und der Motor M bilden zusammen einen Einklemmschutz 26 zum Erkennen eines Hindernisses im Wege der Heckklappe 6.

Die Segmente 12 weisen in diesem Ausführungsbeispiel jeweils einen Detektionsbereich auf, der eine Ausdehnung S vor dem Sensor 8 in Richtung zur Gegenelektrode 15 aufweist. Der Detektionsbereich hat für alle Segmente 12 dieselbe Ausdehnung.

Wenn ein Hindernis in den Detektionsbereich eines der Segmente 12 eindringt, so ändert sich für dieses Segment 12 die erfasste Kapazität. Die Steuereinheit 20 wertet diese Kapazitätsänderung als ein Störsignal aus. Die Steuereinheit 20 ist derart eingerichtet, dass sie bei Störsignalen aus den unterschiedlichen Segmentgruppen 18a, 18b, 18c den Motor M unterschiedlich ansteuert. So ist z.B. in diesem Ausführungsbeispiel die Steuereinheit 20 dafür ausgebildet, bei einem Störsignal aus einem oder mehreren Segmenten 12 der ersten, radial inneren Segmentgruppe 18a, den Motor M langsam abzubremsen, insbesondere über eine PWM-Regelung, ihn dann stromlos zu schalten und ihn anschließend sanft in Reversierrichtung (zum Öffnen der Heckklappe 6) laufen zu lassen. Dieser mechanikschonende Betrieb des Motors M ist dank der langsamen Bahngeschwindigkeit möglich, mit der sich der radial innere Bereich der Heckklappe 6, an dem die erste Segmentgruppe 18a angeordnet ist, beim Schließen der Heckklappe 6 auf die Karosserie 4 hin bewegt.

Wenn das Störsignal aus der zweiten, mittigen Segmentgruppe 18b generiert wurde, muss die Reaktionszeit des Systems kürzer sein, da sich der entsprechende radial mittige Bereich des Heckklappe 6 schneller bewegt als der radial innere. Somit schaltet die Steuereinheit 20 den Motor M sofort ab, und nach einer kuren Stillstandszeit, in der sich der Antrieb entspannen kann, steuert sie den Motor M in Reversierrichtung.

Beim Erkennen eines Hindernisses im Detektionsbereich der dritten, radial äußeren Segmentgruppe 18c wird der Motor M unverzüglich in Reversierrichtung angesteuert. Dies ist notwendig, da sich der entsprechende äußere Bereich der Heckklappe 6 mit einer höheren Bahngeschwindigkeit als die anderen Bereiche bewegt und weniger Zeit zur Reaktion vor einem Einklemmen des Hindernisses vorhanden ist.

Der Aufbau eines beispielhaften Sensors 8', der als Multisensor für eine berührungslose sowie wie für eine taktile Detektion eines Hindernisses ausgebildet ist, ist in Fig. 4 gezeigt. Der Sensor 8' beruht insbesondere auf dem kapazitiven Messprinzip. Der in Fig. 4 dargestellte Sensor 8' umfasst zunächst einen Grundaufbau aus zwei äußeren Grundelektroden 28 sowie eine zwischen den Grundelektroden 28 verlaufende flache Innenelektrode 30. An den Schmalseiten der Innenelektrode 30 sind wiederum zwei Flachleiter 28' angeordnet, die mit den Grundelektroden 28 jeweils elektrisch kontaktiert sind. Die hierdurch insgesamt gebildete Grundelektrode 28, 28' ist mit dem Grundpotential 32, insbesondere dem Erdpotential, verbunden. In Längsrichtung des Flachbandkabels ist die Innenelektrode 30 in mehrere voneinander isolierte Segmente unterteilt. Eines dieser Segmente wird durch den gezeigten Schnitt erfasst. Jede dieser Segmente verfügt über eine separate Zuleitung 34, über die jeweils die Kapazität zwischen des Segments und der Innenelektrode 30 und der Grundelektrode 28 gemessen bzw. ausgewertet werden kann. Die separaten Zuleitungen 34 sind dabei innerhalb eines die Grundelektrode 28 und die Innenelektrode 30 trennenden, isolierenden und elastischen Materials 36 angeordnet.

Die Grundeinheit umfassend die Grundelektrode 28,28', die Innenelektrode 30, die Zuleitungen 34 sowie die zwischen den Elektroden angeordnete Schicht aus dem elastischen Material 36 wirkt als ein taktiler kapazitiver Sensor. Zur Bestimmung der Kapazität zwischen den Grundelektroden 28, 28' und der Innenelektrode 30 wird die Grundelektrode 28 auf ein Grundpotential, insbesondere auf Erdpotential, gelegt und die Innenelektrode 30 demgegenüber mit einer Wechselspannung beaufschlagt. Mit einer geeigneten Auswerteschaltung kann hiermit leicht die sich ausbildende Kapazität gemessen werden.

Erfolgt durch einen externen Gegenstand eine Krafteinwirkung auf den Sensor 8' in Richtung des dargestellten Kraftvektors K, so führt dies zu einer Komprimierung der Schichten aus dem elastischen Material 36. Somit verändert sich die Dicke des elastischen Materials 36. Da die Kapazität des die Grundelektrode 28 und die Innenelektrode 30 umfassenden Kondensators von deren Abstand und somit von der Dicke des isolierenden Materials 36 abhängt, führt die gezeigte Krafteinwirkung zu einer Änderung der Kapazität, so dass eine Berührung des Sensors 8' detektierbar wird. Dabei genügt bei dem sich als Flachbandkabel erstreckenden Sensor 8' eine lokal begrenzt wirkende Kraft, um eine detektierbare Kapazitätsänderung hervorzurufen.

Zur Auswertung des Sensors 8' als taktiler Sensor sind die Segmente der Innenelektrode 30 über ihre jeweils separaten Zuleitungen 34 mittels einer Verbindungsleitung 44 an die Steuereinheit 20 angeschlossen. Hierbei registriert die Steuereinheit 20 eine Änderung der Kapazität zwischen der Grundelektrode 28 und dem jeweiligen Segment der Innenelektrode 30. Ändert sich der Abstand zwischen der oberen und der unteren Grundelektrode 28 und der Innenelektrode 30, so resultiert hieraus eine Kapazitätsänderung, was auf eine Kraft- bzw. Druckeinwirkung an der Stelle des ausgewerteten Segments hinweist. Durch eine serielle Auswertung der Segmente der Innenelektrode 30 kann somit eine Ortsauflösung des taktilen kapazitiven Sensors 8' erreicht werden.

Zusätzlich umfasst der Sensor 8' gemäß Fig. 4 eine wiederum als Flachleiter ausgebildete Elektrode 38, die der oberen Grundelektrode 28 gegenüber angeordnet ist. Zwischen der Elektrode 38 und der oberen Grundelektrode 28 ist eine ebenfalls als Flachleiter ausgebildete Abschirmelektrode 40 angeordnet. Die Elektroden 38 und 40 sind in das isolierende Material 36 eingebettet. Die Baueinheit, bestehend aus oberer Grundelektrode 28, Abschirmelektrode 40 und Elektrode 38 arbeitet als ein berührungsloser, auf dem kapazitiven Messprinzip beruhender Näherungssensor, was im Folgenden beschrieben wird.

Zur Nutzung des Sensors 8' als ein berührungsloser Näherungssensor wird die Elektrode 38 mittels der Signalleitung 46 mit einer Wechselspannung beaufschlagt. Die Wechselspannung wird hierbei durch einen Signalgenerator 45 gegenüber dem Erdpotential erzeugt. Weiter wird mittels der Verbindungsleitung 47 die Abschirmelektrode 40 mit einer Wechselspannung beaufschlagt, die aus der der Elektrode 38 zugeleiteten Wechselspannung abgeleitet ist. Hierfür ist zwischen der Signalleitung 46 und der Verbindungsleitung 47 ein als Operationsverstärker ausgebildetes Schaltmittel 48 eingesetzt. Auf diese Weise wird sichergestellt, dass die Elektrode 38 und die Abschirmelektrode 40 sich ohne zeitliche Verzögerung auf demselben Potential befinden.

Infolge der sich auf gleichem Potential befindlichen Elektrode 38 und Abschirmelektrode 40 bildet sich zwischen der Elektrode 38 und der oberen Grundelektrode 28 keine direkte Kapazität. Diese wird direkt von der Abschirmelektrode 40 und der oberen Grundelektrode 28 gebildet. Stattdessen entsteht zwischen den Kanten der Elektrode 38 und der Masse der Grundelektrode 28 sowie insbesondere einer auf Masse liegenden Karosserie eines Kraftfahrzeugs ein weit in den Raum hinausragendes elektrisches Feld, wodurch ein großer Raum zur Detektion von Hindernissen verfügbar wird. Dabei ist die durch die Elektrode 38 und Masse gebildete Kapazität infolge des Abschirmeffektes durch die Abschirmelektrode 40 deutlich gegenüber einer direkten Kapazität verringert. Zur Messung der Kapazitätsänderung bei Eindringen eines Hindernisses ist die Steuereinheit 20 mittels einer Verbindungsleitung 43 mit der Elektrode 38 verbunden. Die Steuereinheit 20 detektiert hierbei das Verhältnis aus Kapazitätsänderung $\Delta C$ zur Kapazität C. Zur Detektion der Kapazität kann entweder eine Messbrücke verwendet oder die Ladekonstante beobachtet werden.

Bei dem in Fig. 4 gezeigten Sensor 8' handelt es sich somit um einen Multisensor, der die Funktionen eines taktilen kapazitiven und eines berührungslosen kapazitiven Sensors vereinigt. Der Sensor 8' bietet somit eine hohe Ausfallsicherheit und eignet sich insbesondere zur sicheren Erkennung eines Hindernisses im Schließweg eines Steilelementes 6 eines Kraftfahrzeugs 2.

Bezugszeichenliste

| 2 | Kraftfahrzeug |
|---|---|
| 4 | Karosserie |
| 6 | Heckklappe |
| 8 | berührungsloser Sensor |
| 8' | berührungsloser und taktiler Sensor |
| 10 | flexible Leiterstruktur |
| 12 | Segment |
| 14 | Elektrode |
| 15 | Gegenelektrode |
| 16 | Durchkontaktierung |
| 18a, 18b, 18c | Segmentgruppen |
| 20 | Steuereinheit |
| 22 | Signalleitung |
| 24 | Steuerleitung |
| 26 | Einklemmschutz |
| 28, 28' | Grundelektrode |
| 30 | Innenelektrode |
| 32 | Grundpotential |
| 34 | Zuleitung |
| 36 | Material |
| 38 | Elektrode |
| 40 | Abschirmelektrode |
| 44 | Verbindungsleitung |
| 45 | Signalgenerator |
| 46 | Signalleitung |
| 47 | Verbindungsleitung |
| 48 | Schaltmittel |

| A | Drehachse |
|---|---|
| K | Kraftvektor |
| M | Motor |
| $P_1$, $P_2$ | Punkte |
| R | Radialrichtung |
| | Radialentfernung |
| S | Detektionsabstand |
| | Bahngeschwindigkeit |
| $\overline{\omega}$ | Winkelgeschwindigkeit |

**Patentansprüche**

1. Einklemmschutz (26), umfassend einen Motor (M) zum Antrieb eines um eine Drehachse (A) schwenkbaren Stellelements (6) eines Kraftzeugs (2), einen Sensor (8) zum berührungslosen Erkennen eines Hindernisses im Weg des Stellelements (6) mit einer Elektrode (14, 30) zur Erzeugung eines äußeren elektrischen Feldes gegenüber einer Gegenelektrode (15), wobei die Elektrode (14) sich in eine Radialrichtung (R) bezüglich des schwenkbaren Stellelements (6) erstreckt und in der Radialrichtung (R) in mehrere Segmente (12) unterteilt ist, die jeweils zur Generation eines Störsignals getrennt auswertbar sind, **gekennzeichnet durch** eine Steuereinheit (20), die dafür eingerichtet ist, mittels der Segmentierung den radialen Abstand des Hindernisses zur Drehachse (A) zu erfassen, und den Motor (M) abhängig vom festgestellten Radialabstand anzusteuern.

2. Einklemmschutz (26) nach Anspruch 1, wobei die Steuereinheit (20) dafür eingerichtet ist, bei einem von einem ersten radial innenliegenden Segment (12) generierten Störsignal den Motor (M) langsamer anzuhalten als bei einem Störsignal von einem zweiten radial außenliegenden Segment (12).

3. Einklemmschutz (26) nach Anspruch 2, wobei die Steuereinheit (20) dafür eingerichtet ist, den Motor zum Anhalten reversierend anzusteuern.

4. Einklemmschutz nach einem der vorhergehenden Ansprüche, wobei die Elektrode (14) eine erste radial innenliegende, eine zweite radial mittige und eine dritte radial außenliegende Segmentgruppe (18a, 18b, 18c) aufweist.

5. Einklemmschutz (26) nach Anspruch 4, wobei die Steuereinheit (20) dafür eingerichtet ist, bei einem Störsignal aus der ersten Segmentgruppe (18a) den Motor (M) sanft anzuhalten oder abzubremsen.

6. Einklemmschutz (26) nach Anspruch 5, wobei die Steuereinheit (20) dafür eingerichtet ist, über eine PWM-Regelung den Motor (M) zu steuern.

7. Einklemmschutz (26) nach einem der Ansprüche 4 bis 6, wobei die Steuereinheit (20) dafür eingerichtet ist, bei einem Störsignal aus der zweiten Segmentgruppe (18b) den Motor (M) sofort abzuschalten.

8. Einklemmschutz (26) nach einem der Ansprüche 4 bis 7, wobei die Steuereinheit (20) dafür eingerichtet ist, bei einem Störsignal aus der dritten Segmentgruppe (18c) den Motor (M) unverzüglich in Reversierrichtung anzusteuern.

9. Einklemmschutz (26) nach einem der Ansprüche 4 bis 8, wobei mindestens eine der Segmentgruppen (18a, 18b, 18c) derart ausgebildet ist, dass ein im Wesentlichen stufenloser Übergang beim Ansteuern des Motors (M) bezüglich der benachbarten Segmente (12) innerhalb der Segmentgruppe (18a, 18b, 18c) erfolgt.

10. Einklemmschutz (26) nach einem der vorhergehenden Ansprüche, wobei die Elektrode (14) in einem flexiblen Träger geführt ist.

11. Einklemmschutz (26) nach Anspruch 10, wobei im flexiblen Träger zusätzlich eine Abschirmelektrode (28) zur Richtung des elektrischen Feldes in einen Gefährdungsbereich vorgesehen ist.

12. Einklemmschutz (26) nach Anspruch 11, wobei die Abschirmetektrode (28) in elektrisch kontaktierte Abschirmsegmente (28, 28') unterteilt ist, zwischen denen isoliert separate Zuleitungen (34) angeordnet sind.

13. Einklemmschutz (26) nach Anspruch 11 oder 12, wobei Schaltmittel (48) zur Potenzialangleichung zwischen der Elektrode (14) und der Abschirmelektrode (28) vorgesehen sind.

14. Einklemmschutz (26) nach einem der Ansprüche 11 bis 13, wobei zur Potenzialangleichung ein Verstärker vorgesehen ist, der ausgangsseitig mit der Abschirmelektrode (28) zur Versorgung mit einem aus der Signalleitung (46) abgeleiteten Signal verbunden ist.

15. Einklemmschutz (26) nach einem der vorhergehenden Ansprüche mit zusätzlich einem taktilen Sensor (8').

**Claims**

1. Anti-pinch device (26) comprising a motor (M) for driving an actuating element (6) of a motor vehicle (2), said actuating element (6) being pivotable along a rotary axis (A), a sensor (8) for non-contact detection of an obstacle in the path of the actuating element (6) with an electrode (14, 30) for generating an external electric field relative to a counter electrode (15), wherein the electrode (14) extends in a radial direction (R) relative to the pivotable actuating element (6) and is divided into a plurality of segments (12) in the radial direction (R), each of which can be evaluated separately for generating an interference signal, **characterized in** a control unit (20), which is configured for determining the radial distance of the obstacle to the rotary axis (A) by means of segmentation and to control the motor (M) depending on the determined radial distance.

2. Anti-pinch device (26) according to claim 1, wherein the control unit (20) is configured to stop the motor (M) more slowly when receiving an interference signal from a first radially inner segment (12) than when receiving an interference signal from a second radially outer segment (12).

3. Anti-pinch device (26) according to claim 2, wherein the control unit (20) is configured to reversibly control the motor to stop said motor.

4. Anti-pinch device according to one of the previous claims, wherein the electrode (14) comprises a first radially inner, a second radially central and a third radially outer segment group (18a, 18b, 18c).

5. Anti-pinch device (26) according to claim 4, wherein the control unit (20) is configured to gently stop or slow the motor (M) when receiving a signal from the first segment group (18a).

6. Anti-pinch device (26) according to claim 5, wherein the control unit (20) is configured for controlling the motor (M) by means of a PWM regulation.

7. Anti-pinch device (26) according to one of the claims 4 to 6, wherein the control unit (20) is configured for immediately stopping the motor (M) when receiving an interference signal from the second segment group (18b).

8. Anti-pinch device (26) according to one of the claims 4 to 7, wherein the control unit (20) is configured for immediately running the motor (M) in a reverse direction when receiving a signal from the third segment group (18c).

9. Anti-pinch device (26) according to one of the claims 4 to 8, wherein at least one of the segment groups (18a, 18b, 18c) is configured such that when the motor is run, a substantially continuous transition occurs within the segment group (18a, 18b, 18c) relative to the neighboring segments (12).

10. Anti-pinch device (26) according to one of the previous claims, wherein the electrode (14) is guided in a flexible carrier.

11. Anti-pinch device (26) according to claim 10, wherein in addition a shielding electrode (28) for directing the electric field into a hazard region is provided in the flexible carrier.

12. Anti-pinch device (26) according to claim 11, wherein the shielding electrode (28) is divided into electrically contacted shielding segments (28, 28'), between which separately isolated lines (34) are arranged.

13. Anti-pinch device (26) according to claim 11 or 12, wherein a switch (48) is provided for potential equalization between the electrode (14) and the shielding electrode (28).

14. Anti-pinch device (26) according to one of the claims 11 to 13, wherein an amplifier is provided for the potential equalization and said amplifier is connected to the shielding electrode (28) on the output side to supply a signal derived from the signal line (46).

15. Anti-pinch device (26) according to one of the previous claims having in addition a tactile sensor (8').

**Revendications**

1. Protection anti-coincement (26) comprenant un moteur (M) pour entraîner un élément de réglage (6) d'un véhicule (2) pivotant autour d'un axe de rotation (A), un capteur (8) pour détecter sans contact un obstacle sur le chemin de l'élément de réglage (6), avec une électrode (14, 30) pour générer un champ électrique extérieur par rapport à une contre-électrode (15), l'électrode (14) s'étendant dans une direction radiale (R) par rapport à l'élément de réglage pivotant (6) et étant subdivisée, dans le sens radial (R), en plusieurs segments (12) qui peuvent chacun être évalués séparément pour générer un signal de perturbation, **caractérisée par** une unité de commande (20) qui est aménagée pour saisir la distance radiale entre l'obstacle et l'axe de rotation (A) au moyen de la segmentation et pour commander le moteur (M) en fonction de la distance radiale constatée.

2. Protection anti-coincement (26) selon la revendication 1, l'unité de commande (20) étant aménagée pour arrêter le moteur (M) plus lentement dans le cas d'un signal de perturbation généré par un premier segment radialement intérieur (12) que dans le cas d'un signal de perturbation d'un deuxième segment radialement extérieur (12).

3. Protection anti-coincement (26) selon la revendication 2, l'unité de commande (20) étant aménagée pour commander le moteur en sens inverse pour l'arrêter.

4. Protection anti-coincement selon l'une des revendications précédentes, l'électrode (14) comportant un premier groupe de segments radialement intérieur, un deuxième groupe de segments radialement central et un troisième groupe de segments radialement extérieur (18a, 18b, 18c).

5. Protection anti-coincement (26) selon la revendication 4, l'unité de commande (20) étant aménagée pour arrêter ou freiner le moteur (M) en douceur dans le cas d'un signal de perturbation provenant du premier groupe de segments (18a).

6. Protection anti-coincement (26) selon la revendication 5, l'unité de commande (20) étant aménagée pour commander le moteur (M) via un réglage MID.

7. Protection anti-coincement (26) selon l'une des revendications 4 à 6, l'unité de commande (20) étant aménagée pour couper immédiatement le moteur (M) dans le cas d'un signal de perturbation provenant du deuxième groupe de segments (18b).

8. Protection anti-coincement (26) selon l'une des revendications 4 à 7, l'unité de commande (20) étant aménagée pour commander sans délai le moteur (M) en sens inverse dans le cas d'un signal de perturbation provenant du troisième groupe de segments (18c).

9. Protection anti-coincement (26) selon l'une des revendications 4 à 8, au moins l'un des groupes de segments (18a, 18b, 18c) étant réalisé de manière telle que, en ce qui concerne les segments voisins (12) du groupe de segments (18a, 18b, 18c), il y a passage sensiblement continu lors de la commande du moteur (M).

10. Protection anti-coincement (26) selon l'une des revendications précédentes, l'électrode (14) étant enfilée dans un support flexible.

11. Protection anti-coincement (26) selon la revendication 10, une électrode de protection (28) étant additionnellement prévue dans le support flexible pour diriger le champ électrique vers une zone dangereuse.

12. Protection anti-coincement (26) selon la revendication 11, l'électrode de protection (28) étant subdivisée en segments de protection (28, 28') contactés électriquement entre lesquels sont situées, de manière isolée, des lignes d'amenée (34) séparées.

13. Protection anti-coincement (26) selon la revendication 11 ou 12, des moyens de commutation (48) étant prévus pour équilibrer le potentiel entre l'électrode (14) et l'électrode de protection (28).

14. Protection anti-coincement (26) selon l'une des revendications 11 à 13, un amplificateur étant prévu pour équilibrer le potentiel, lequel amplificateur est relié, côté sortie, à l'électrode de protection (28) pour alimentation avec un signal dérivé de la ligne de signaux (46).

15. Protection anti-coincement (26) selon l'une des revendications précédentes, comportant additionnellement un capteur tactile (8').

**FIG. 1**

**FIG. 2**

FIG. 3

FIG. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1455044 A2
- EP 1154110 A2

- US 20060117862 A1